# FASCICULE DE BREVET EUROPEEN

(11) **EP 3 319 115 B1**
(45) Date de publication et mention de la délivrance du brevet: **29.06.2022**
(21) Numéro de dépôt: 17168180.2
(22) Date de dépôt: 26.04.2017
(51) Int. Cl.: H01L 23/00, H01L 21/60, H01L 23/49, H01L 23/552, H01L 23/66, H01L 23/31, H01L 21/56

(54) **PROCÉDÉ DE RÉALISATION D'UNE CONNEXION ÉLECTRIQUE ENTRE UNE PUCE ÉLECTRONIQUE ET UNE PLAQUE DE SUPPORT ET DISPOSITIF ÉLECTRONIQUE**
VERFAHREN ZUR HERSTELLUNG EINER ELEKTRISCHEN VERBINDUNG ZWISCHEN EINEM ELEKTRONISCHEN CHIP UND EINER TRÄGERPLATTE, UND ELEKTRONISCHE VORRICHTUNG
PROCESS FOR MAKING AN ELECTRIC CONNECTION BETWEEN AN ELECTRONIC DIE AND AN SUPPORT PLATE AND ELECTRONIC DEVICE

(30) Priorité: 03.11.2016 FR 1660623
(43) Date de publication de la demande: 09.05.2018
(73) Titulaire: STMicroelectronics (Grenoble 2) SAS, 38000 Grenoble (FR)
(72) Inventeur: LOPEZ, Jérôme, 38134 SAINT-JOSEPH-DE-RIVIERE (FR); QUERCIA, Fabien, 38160 SAINT MARCELIN (FR); HAJJI, Asma, 38140 RIVES (FR); AUCHERE, David, 38400 SAINT MARTIN D'HERES (FR)
(74) Mandataire: Casalonga

(56) Documents cités:
- JP-A- 2000 058 579
- JP-A- 2000 286 367
- JP-A- 2013 197 531
- US-A- 6 084 295

## Description

La présente invention concerne le domaine des dispositifs électroniques et plus particulièrement ceux qui comprennent des puces électroniques montées sur des plaques de support, incluant des réseaux de connexion électrique ou des grilles de connexion électrique, et des fils de connexion électrique qui relient les puces aux plaques de support.

Le document JP 2000 058579 décrit un dispositif électronique dans lequel la puce, les enrobages et le fil électrique gainé, en totalité, sont noyés dans un bloc épais et large en une matière conductrice de l'électricité, au-dessus de la plaque de support.

Le document JP 2013 197531 décrit un dispositif semiconducteur comprenant une puce et une résine de scellement scellant la puce sur une plaque de support ainsi que les fils de connexion électriques. Chaque partie située entre un fil de connexion et une partie de la puce est recouverte par une résine de protection et toute la surface de la résine de protection est recouverte par la résine de scellement.

Dans le cas où des fils de connexion électrique transportent des signaux notamment à des fréquences élevées, ces signaux peuvent être atténués ou peuvent être perturbés par des champs électromagnétiques environnants et/ou émettent des champs électromagnétiques qui peuvent perturber l'environnement.

A l'heure actuelle, pour réduire cette difficulté, il est proposé d'adjoindre aux dispositifs électroniques des plaques métalliques de blindage, éventuellement reliées à une masse. Néanmoins, la mise en place et la connexion électrique à une masse de telles plaques métalliques de blindage, combinées avec la réalisation de blocs d'encapsulation ou à la mise en place de couvercles d'encapsulation, posent des difficultés et sont onéreuses. De plus, comme les blindages obtenus sont globaux et à distance des fils de connexion électrique, la protection électromagnétique obtenue reste insuffisante.

Différents aspects de l'invention sont définis dans les revendications annexées.

Selon un mode de réalisation, il est proposé un procédé de réalisation d'une connexion électrique entre une puce électronique et une plaque de support sur laquelle cette puce est montée, le procédé étant selon la revendication 1.

Le procédé peut comprendre en outre les étapes suivantes :
mettre en place un fil complémentaire de connexion électrique entre un plot découvert de connexion électrique de la puce électronique et un plot découvert de connexion électrique de la plaque de support et réaliser des jonctions électriques entre les extrémités de ce fil complémentaire et ces plots, et
réaliser le blindage local conducteur de sorte que ce blindage local conducteur soit en contact avec ce fil complémentaire de connexion électrique et/ou avec au moins l'un de ces plots de connexion électrique.

Un mode de fabrication va maintenant être décrit à titre d'exemple non limitatif, illustré par le dessin annexé dans lequel :
- la figure 1 représente une vue en coupe d'un dispositif électronique en cours de fabrication, selon une étape de fabrication ;
- la figure 2 représente une vue de dessus du dispositif électronique de la figure 1 ;
- la figure 3 représente une vue en coupe du dispositif électronique en cours de fabrication, selon une étape ultérieure de fabrication ;
- la figure 4 représente une vue de dessus du dispositif électronique de la figure 3 ;
- la figure 5 représente une vue en coupe du dispositif électronique en cours de fabrication, selon une étape ultérieure de fabrication, montrant le dispositif électronique obtenu ; et
- la figure 6 représente une vue de dessus du dispositif électronique de la figure 5.

Comme illustré sur les figures, un dispositif électronique 1 comprend une plaque de support 2 et une puce électronique 3, incluant des circuits intégrés, dont une face arrière 4 est fixée sur une face avant 5 de la plaque de support 2, par l'intermédiaire d'une couche de colle (non représentée).

La plaque de support 2 est en une matière diélectrique et inclut un réseau intégré de connexion électrique 6, à un ou plusieurs niveaux métalliques, qui comprend des plots avant découverts de connexion électrique 7 et 8 de la face avant 5 et qui sont situés latéralement à distance d'un flanc 9 de la puce électronique 3 et à proximité l'un de l'autre.

La puce électronique 3 comprend des plots avant découverts de connexion électrique 10 et 11 d'une face avant 12 de cette puce électronique 3, opposée à sa face arrière 4, et qui sont situés à distance du flanc 9 de la puce électronique 3, non loin des plots avant 7 et 8 de la plaque de support 2.

On va maintenant décrire des étapes en vue de réaliser des connexions électriques entre les plots 7 et 10 et, optionnellement, les plots 8 et 11, respectivement de la plaque de support 2 et de la puce électronique 3.

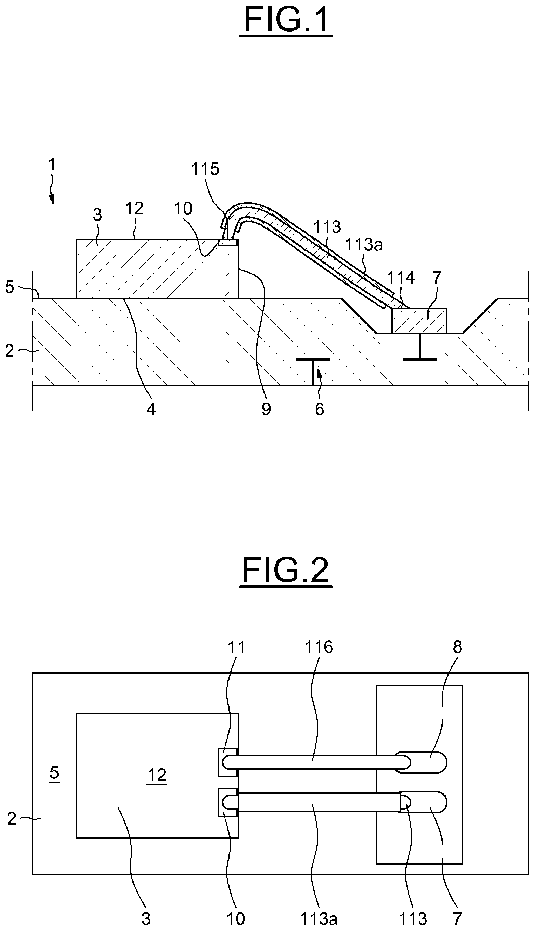

Selon une étape illustrée sur les figures 1 et 2, d'une part on met en place un fil de connexion électrique 113, entouré d'une gaine 113a en une matière diélectrique, entre les plots découverts de connexion électrique 7 et 10 et on réalise par soudure des jonctions électriques 114 et 115 respectivement entre les extrémités du fil de connexion électrique 113 et les plots 7 et 10 et, d'autre part, on met en place un fil complémentaire de connexion électrique 116, nu ou entouré d'une gaine isolante, entre les plots complémentaires découverts de connexion électrique 8 et 11 et on réalise par soudure des jonctions électriques respectivement entre les portions d'extrémité du fil de connexion électrique 116 et les plots 8 et 11. Les fils de connexion électrique 113 et 116 sont voisins mais distants l'un de l'autre.

Cette opération de mise en place des fils de connexion électrique 113 et 116 peut être réalisée à l'aide d'une machine adaptée de pose et de soudage, bien connue sous le vocable anglais de « wire bonding ».

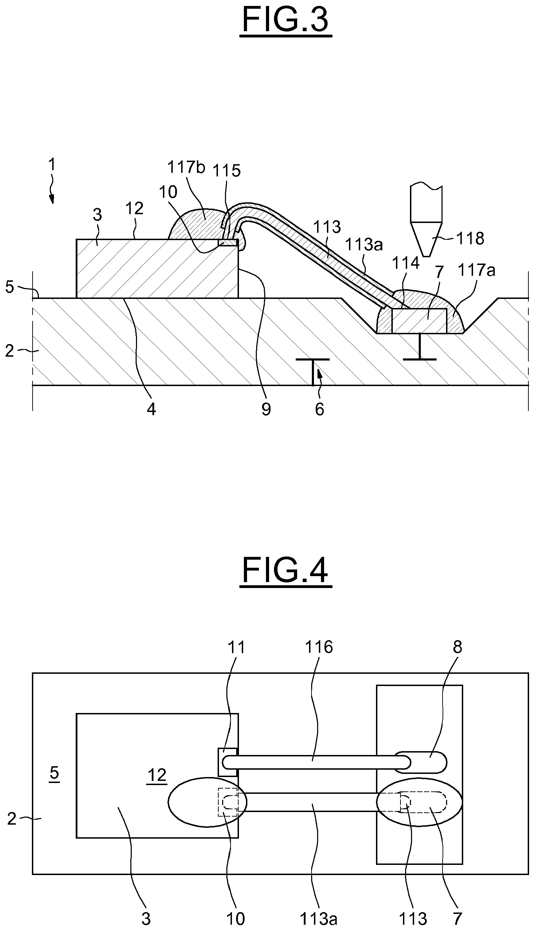

Selon une étape ultérieure illustrée sur les figures 3 et 4, on distribue localement une quantité déterminée d'une matière diélectrique liquide adhérente au-dessus du plot 7 et/ou de la jonction 114 et/ou de la portion d'extrémité de la gaine isolante 113a adjacente à la jonction 114, de sorte que cette matière diélectrique recouvre complètement le plot 7 et la jonction 114 et entoure complètement la portion d'extrémité de la gaine isolante 113a adjacente à la jonction 114. Après durcissement, cette matière diélectrique réalise un premier enrobage local diélectrique 117a.

De façon équivalente, on distribue localement une quantité déterminée d'une matière diélectrique liquide adhérente au-dessus du plot 10 et/ou de la jonction 115 et/ou de la portion d'extrémité de la gaine isolante 113a adjacente à la jonction 115, de sorte que cette matière diélectrique recouvre complètement le plot 7 et la jonction 115 et entoure complètement la portion d'extrémité de la gaine isolante 113a adjacente à la jonction 115. Après durcissement, cette matière diélectrique réalise un second enrobage diélectrique local 117b.

Ces opérations sont réalisées à l'aide d'un outil contrôlé adapté comprenant une seringue 118 de distribution contrôlée, apte à délivrer au moins une goutte calibrée de la matière diélectrique liquide, cette matière diélectrique liquide s'écoulant pour en fin de compte recouvrir les plots 7 et 10 et les jonctions 114 et 115 et entourer les portions correspondantes d'extrémité de la gaine isolante 113a, notamment par effet de capillarité ou de mouillage.

Puis, la matière diélectrique liquide est durcie pour constituer les enrobages diélectriques 117a et 117b, grâce à ses qualités intrinsèques de durcissement à la température ambiante ou de durcissement sous l'effet d'une source de chaleur ou de rayonnement lumineux. Par exemple, la matière diélectrique peut être une résine époxy adaptée.

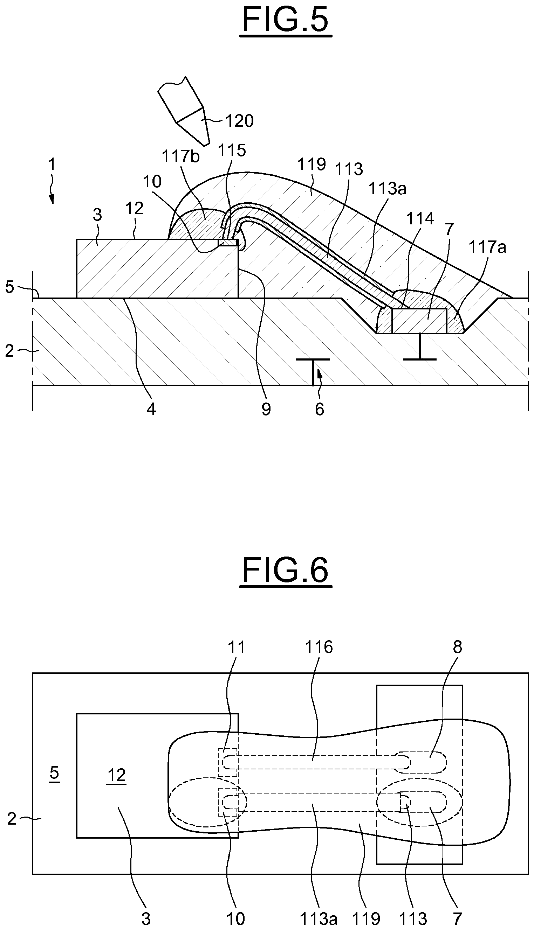

Selon une étape ultérieure illustrée sur les figures 5 et 6, on distribue localement une quantité déterminée d'une matière liquide adhérente conductrice de l'électricité, de sorte que cette matière conductrice entoure complètement la gaine isolante 113a, recouvre les enrobages diélectriques locaux 117a et 117b et soit en contact avec le fil de connexion électrique 116 et/ou les plots 8 et 11, cette matière conductrice débordant éventuellement sur les faces avant 5 et 12 de la plaque de support 2 et de la puce électronique 3. Après durcissement, cette matière conductrice réalise un blindage local conducteur de l'électricité 119 au plus près du fil de connexion électrique 113 et relié au fil de connexion électrique 116 et aux plots 8 et 11.

Cette opération est réalisée à l'aide d'un outil adapté comprenant une seringue 120 de distribution contrôlée, apte à délivrer respectivement au moins une goutte calibrée de la matière conductrice liquide, cette matière conductrice liquide s'écoulant notamment par effet de capillarité ou de mouillage.

Puis, la matière conductrice liquide est durcie pour constituer le blindage local conducteur 119, grâce à ses qualités intrinsèques de durcissement à la température ambiante ou de durcissement sous l'effet d'une source de chaleur ou de rayonnement lumineux. Par exemple, la matière conductrice peut être une résine époxy chargée de particules métalliques.

Le fil de connexion électrique 113 est destiné au transport de signaux électriques entre les plots 7 et 10 de la plaque de support 2 et de la puce électronique 3. Le blindage conducteur 119 constitue une protection électromagnétique de ces signaux électriques.

Les plots 8 et 11, reliés par le fil de connexion électrique 116, constituent des plots de masse des circuits électriques du dispositif électronique 1. Ainsi, le blindage conducteur 119, qui est relié aux plots 8 et 11 et au fil de connexion électrique 116, est relié à la masse des circuits électriques du dispositif électronique 1.

Selon une variante de réalisation, le fil de connexion électrique 116 pourrait être supprimé.

Bien entendu, le dispositif électronique 1 peut comprendre d'autres fils de connexion électrique 113 reliant d'autres plots 7 et 10 de la plaque de support 2 et de la puce électronique 3 et d'autres fils de connexion électrique 116 reliant d'autres plots 8 et 11 de la plaque de support 2 et de la puce électronique 3, également équipés d'enrobages diélectriques locaux 117a et 117b et de blindages conducteurs locaux 119, dont les étapes de réalisation seraient respectivement communes.

Selon une variante de réalisation, la plaque de support 2 pourrait comprendre une grille métallique comprenant une plateforme sur laquelle serait montée la puce électronique 3, les fils de connexion électrique 113 et 116 reliant la puce électronique 3 à des pattes périphériques de cette grille.

## Revendications

1. Procédé de réalisation d'une connexion électrique entre une puce électronique (3) et une plaque de support (2) sur laquelle cette puce est montée, comprenant les étapes suivantes :
mettre en place un fil de connexion électrique (113) entre un plot découvert de connexion électrique (10) de la puce électronique et un plot découvert de connexion électrique (7) de la plaque de support et réaliser des jonctions électriques (114,115) entre les extrémités du fil de connexion électrique et les plots, le fil de connexion électrique étant pourvu d'une gaine isolante (113a) en une matière diélectrique qui l'entoure ;
réaliser des premier et second enrobages locaux diélectriques (117a, 117b) en une matière diélectrique, qui respectivement recouvrent lesdits plots et les jonctions adjacentes et entourent une portion adjacente d'extrémité de la gaine isolante, par distributions locales de quantités déterminées de la matière diélectrique à l'état liquide, respectivement sous la forme d'une goutte calibrée qui s'écoule par effet de capillarité ou de mouillage, à l'aide d'un outil contrôlé comprenant une seringue de distribution contrôlée (118), et durcissement de cette matière diélectrique, et
réaliser un blindage local conducteur (119) en une matière conductrice de l'électricité, qui recouvre lesdits enrobages locaux diélectriques et entoure la gaine isolante, par distribution locale d'une quantité déterminée d'une matière conductrice de l'électricité à l'état liquide, sous la forme d'une goutte calibrée qui s'écoule par effet de capillarité ou de mouillage, à l'aide d'un outil contrôlé comprenant une seringue de distribution contrôlée (120), et durcissement de cette matière conductrice.

2. Procédé selon la revendication 1, comprenant les étapes suivantes :
mettre en place un fil complémentaire de connexion électrique (116) entre un plot découvert de connexion électrique (11) de la puce électronique et un plot découvert de connexion électrique (8) de la plaque de support et réaliser des jonctions électriques entre les extrémités de ce fil complémentaire et ces plots, et
réaliser le blindage local conducteur (119) de sorte que ce blindage local conducteur (119) soit en contact avec ce fil complémentaire de connexion électrique (116) et/ou avec au moins l'un de ces plots de connexion électrique.

## Patentansprüche

1. Verfahren zur Herstellung einer elektrischen Verbindung zwischen einem elektronischen Chip (3) und einer Trägerplatte (2), auf der der Chip montiert ist, die folgenden Schritte umfassend:
Einrichtung eines Drahts der elektrischen Verbindung (113) zwischen einem unbedeckten Kontakt der elektrischen Verbindung (10) des elektronischen Chips und einem unbedeckten Kontakt der elektrischen Verbindung (7) der Trägerplatte und Realisierung von elektrischen Übergängen (114, 115) zwischen den Enden des Drahts der elektrischen Verbindung und den Kontakten, wobei der Draht der elektrischen Verbindung mit einem Isoliermantel (113a) aus einem dielektrischen Material ausgerüstet ist, das ihn umgibt;
Realisierung von ersten und zweiten lokalen dielektrischen Umhüllungen (117a, 117b), aus einem dielektrischen Material, die jeweils die Kontakte und die angrenzenden Übergänge bedecken und einen angrenzenden Bereich des Endes des Isoliermantels umgeben, durch lokale Verteilungen bestimmter Mengen des dielektrischen Materials in flüssigem Zustand, jeweils in Form eines geeichten Tropfens, der durch Kapillar- oder Benetzungswirkung fließt, unter Verwendung eines kontrollierten Werkzeugs, das eine Spritze mit kontrollierter Verteilung (118) umfasst, und Aushärtung des dielektrischen Materials, und
Realisierung einer lokalen leitenden Abschirmung (119) aus einem elektrisch leitenden Material, die die lokalen dielektrischen Umhüllungen bedeckt und den Isoliermantel umgibt, durch lokale Verteilung einer bestimmten Menge eines elektrisch leitenden Materials in flüssigem Zustand, in Form eines geeichten Tropfens, der durch Kapillar-oder Benetzungswirkung fließt, unter Verwendung eines kontrollierten Werkzeugs, das eine Spritze mit kontrollierter Verteilung (120) umfasst, und Aushärtung des leitenden Materials.

2. Verfahren nach Anspruch 1, die folgenden Schritte umfassend: Einrichtung eines komplementären Drahts der elektrischen Verbindung (116) zwischen einem unbedeckten Kontakt der elektrischen Verbindung (11) des elektronischen Chips und einem unbedeckten Kontakt der elektrischen Verbindung (8) der Trägerplatte und Realisierung von elektrischen Übergängen zwischen den Enden des komplementären Drahts und den Kontakten, und Realisierung der lokalen leitenden Abschirmung (119), so dass die lokale leitende Abschirmung (119) in Kontakt mit dem komplementären Draht der elektrischen Verbindung (116) steht und/oder mit mindestens einem der Kontakte der elektrischen Verbindung.

## Claims

1. A method for making an electrical connection between an electronic chip (3) and a support plate (2) on which this chip is mounted, comprising the following steps:
placing an electrical connection wire (113) between an exposed electrical connection pad (10) of the electronic chip and an exposed electrical connection pad (7) of the support plate and making electrical junctions (114, 115) between the ends of the electrical connection wire and the pads, the electrical connection wire being provided with an insulating sheath (113a) made of a dielectric material which surrounds it;
producing first and second local dielectric coatings (117a, 117b) from a dielectric material, which respectively cover said pads and the adjacent junctions and surround an adjacent end portion of the insulating sheath, by local distributions of determined amounts of the dielectric material in the liquid state, respectively in the form of a calibrated drop which flows by capillarity or wetting effect, using a controlled tool comprising a controlled dispensing syringe (118), and hardening this dielectric material, and
producing a local conductive shield (119) from an electrically conductive material, which covers said local dielectric coatings and surrounds the insulating sheath, by local distribution of a determined amount of an electrically conductive material in the liquid state, in the form of a calibrated drop which flows by capillarity or wetting effect, using a controlled tool comprising a controlled dispensing syringe (120), and hardening this conductive material.

2. The method according to claim 1, comprising the following steps:
placing a complementary electrical connection wire (116) between an exposed electrical connection pad (11) of the electronic chip and an exposed electrical connection pad (8) of the support plate and making electrical junctions between the ends of this complementary wire and these pads, and
producing the local conductive shielding (119) so that this local conductive shielding (119) is in contact with this complementary electrical connection wire (116) and/or with at least one of these electrical connection pads.
